(19) Europäisches Patentamt
European Patent Office
Office européen des brevets

(11) **EP 1 250 607 B1**

(12) **FASCICULE DE BREVET EUROPEEN**

(45) Date de publication et mention
de la délivrance du brevet:
**14.11.2007 Bulletin 2007/46**

(51) Int Cl.:
*G01R 31/08* *(2006.01)*  *G01R 31/02* *(2006.01)*
*G01M 3/18* *(2006.01)*

(21) Numéro de dépôt: **01907636.3**

(22) Date de dépôt: **19.01.2001**

(86) Numéro de dépôt international:
**PCT/FR2001/000171**

(87) Numéro de publication internationale:
**WO 2001/055739 (02.08.2001 Gazette 2001/31)**

(54) **PROCEDE ET DISPOSITIF DE CONTROLE D'UN CABLE DE TELECOMMUNICATION**

VERFAHREN UND VORRICHTUNG ZUR ÜBERWACHUNG EINES
TELEKOMMUNIKATIONSKABELS

METHOD AND DEVICE FOR MONITORING A TELECOMMUNICATION CABLE

(84) Etats contractants désignés:
**DE ES FR GB IT**

(30) Priorité: **26.01.2000 FR 0000970**

(43) Date de publication de la demande:
**23.10.2002 Bulletin 2002/43**

(73) Titulaire: **SOCRAT**
**F-83210 Sollies-Pont (FR)**

(72) Inventeur: **BUSSINGER, Jean**
**83136 Sainte Anastasie sur Issole (FR)**

(74) Mandataire: **Marchand, André et al**
**OMNIPAT,**
**24 Place des Martyrs de la Résistance**
**13100 Aix-en-Provence (FR)**

(56) Documents cités:
**EP-A- 0 408 480**    **US-A- 4 103 225**

• **BASCOM E C ET AL: "COMPUTERIZED
UNDERGROUND CABLE FAULT LOCATION
EXPERTISE" PROCEEDINGS OF THE POWER
ENGINEERING SOCIETY TRANSMISSION AND
DISTRIBUTION CONFERENCE,US,NEW YORK,
IEEE, vol. -, 10 avril 1994 (1994-04-10), pages
376-382, XP000470557 ISBN: 0-7803-1883-8**

**Description**

La présente invention concerne un procédé de contrôle d'un élément conducteur applicable à la localisation d'un défaut de continuité de l'élément conducteur. La présente invention concerne notamment le contrôle de la continuité électrique de l'écran métallique d'un câble de télécommunication.

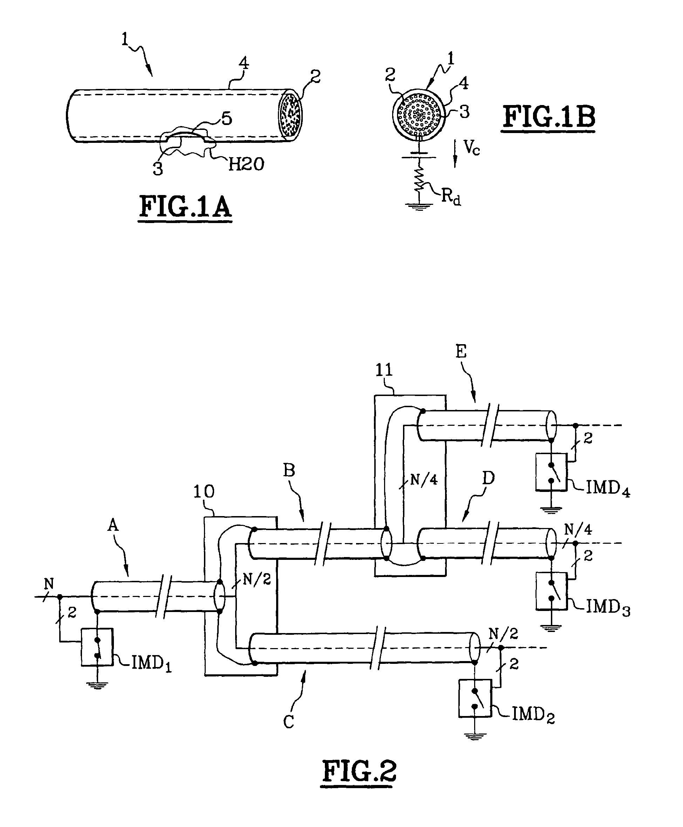

Les réseaux de télécommunication actuels, de structure arborescente, sont réalisés au moyen de câbles 1 de forte section du type représenté en figure 1A, comprenant plusieurs centaines ou milliers de fils électriques 2 isolés les uns des autres par un guipage approprié et agencés deux par deux pour former des paires téléphoniques. L'ensemble est protégé contre les perturbations électriques par une gaine métallique, ou écran 3, lui-même recouvert par une gaine 4 protectrice en un matériau électriquement isolant comme du polyéthylène, du PVC, . . .

De tels câbles de télécommunication, agencés dans le sol ou dans l'air, sont soumis à diverses agressions dont les plus fréquentes sont causées par la foudre, les rongeurs, les travaux de voirie, le frottement des branches d'arbres... Ces diverses agressions peuvent conduire à une déchirure 5 de la gaine protectrice et à une pénétration d'eau dans le câble. Du point de vue électrique, une telle dégradation se traduit par un défaut d'isolement de l'écran 3 vis-à-vis de la terre, schématisé en figure 1B par une résistance Rd, et conduit à l'apparition d'une tension Vc, ou "potentiel d'écran", générée notamment par la combinaison du métal de l'écran 3 avec l'eau et divers oxydes métalliques. Lorsqu'un défaut d'étanchéité n'est pas réparé en temps utile, la dégradation du câble s'étend au guipage des fils électriques et se développe sur une grande longueur de câble en raison de la propagation de l'eau.

Le contrôle de la bonne étanchéité des câbles est ainsi une préoccupation majeure des opérateurs de télécommunication et nécessite de plus en plus d'être automatisé en vue d'une diminution des coûts de maintenance et des temps d'intervention sur site.

Un autre contrôle devant être effectué sur les réseaux de câbles de télécommunication est celui de la continuité électrique des écrans, qui sont généralement connectés à la terre à leurs extrémités pour permettre l'écoulement de charges électriques induites par des perturbations électromagnétiques ou des montées de potentiel électrique dans le sol. Le contrôle de la continuité électrique des écrans entre deux points de connexion à la terre est également à l'heure actuelle une préoccupation majeure des opérateurs de télécommunication, car ces derniers doivent garantir des performances optimales de leurs réseaux en raison de l'augmentation des débits de transfert de données numériques imposée par le développement du réseau Internet et autres applications informatiques.

Ces dernières années, la demanderesse a conçu, développé et perfectionné un système de surveillance automatique des réseaux de télécommunication constitué par un ensemble de dispositifs de mesure commercialisés sous la référence "IMD" (Interface de Mesure Déportée). De tels dispositifs, décrits dans le brevet EP 408 480 et dans la demande internationale PCT/FR99/02288, sont agencés aux points de connexion à la terre des écrans métalliques et reliés par des paires téléphoniques à un équipement local de maintenance, lui-même relié à un centre de maintenance régional. Ils permettent d'effectuer quotidiennement diverses opérations de contrôle et de mesure, notamment :

-    la déconnexion des écrans relativement à la terre et la mesure de la résistance d'isolement des écrans et du potentiel d'écran,
-    la détection et la localisation d'un défaut d'isolement d'un écran par injection d'une tension basse fréquence, conformément à un procédé décrit dans la demande internationale précitée, et
-    la détection d'un défaut de continuité d'un écran, par une méthode dite de la "boucle de terre".

Les câbles de télécommunication présentent toutefois des longueurs non négligeables allant de la centaine de mètres à quelques kilomètres, la localisation d'un défaut d'isolement dans un tronçon de câble au moyen de dispositifs IMD doit être complétée par une étape de localisation précise du défaut sur le terrain afin de procéder à la réparation.

Dans la demande internationale précitée, la demanderesse a proposé un procédé de localisation complémentaire permettant de localiser sur le lieu de réparation l'anomalie affectant une section de câble douteuse. Pour mémoire, ce procédé de localisation complémentaire consiste à injecter dans l'écran de la portion de câble douteuse deux courants de fréquences distinctes, contrairement à l'enseignement de US 4 103 225 dans lequel un courant continu de charge et de décharge est appliqué à un câble pour mesurer sa capacité. Ce procédé de localisation consiste ensuite à mesurer les courants en divers points de l'écran, puis à calculer la partie réelle d'au moins un des deux courants pour s'affranchir de l'influence de la capacité de fuite de l'écran. Une chute brutale de la partie réelle du courant en un point déterminé du câble permet de localiser le défaut d'isolement.

Un problème similaire se pose en ce qui concerne les défauts de continuité électrique, car la méthode de la boucle de terre permet de détecter un défaut de continuité dans une section de réseau sans localisation précise du point de discontinuité. Pour fixer les idées, la figure 2 représente schématiquement un réseau de câbles de télécommunication comprenant un câble "A" comprenant N fils dont l'extrémité est raccordée au moyen d'un boîtier d'épissure 10 à deux câbles "B" et "C" comprenant N/2 fils chacun. Le câble B est lui-même raccordé au moyen d'un boîtier d'épissure 11 à deux câbles "D" et "E" comprenant N/4 fils chacun. L'écran du câble A est connecté aux écrans des câbles B et C et l'écran du câble B est connecté aux écrans des câbles D et E. L'écran du câble A est connecté à la terre en son point d'origine par l'intermédiaire d'un dispositif IMD1 et les écrans des câbles C, D, E sont connectés à la terre en leurs points d'extrémité par l'intermédiaire de dispositifs IMD2, IMD3, IMD4.

Lors d'une mesure de boucle de terre, par exemple dans le tronçon ABE, le dispositif IMD1 maintient le point d'origine de l'écran A connecté à la terre tandis que les dispositifs IMD2, IMD3, IMD4 déconnectent les points d'extrémité des écrans C, D, E. Le dispositif IMD4 mesure la résistance de la boucle constituée par la résistance des écrans ABE, la résistance de terre du dispositif IMD1 et sa propre résistance de terre. Si la résistance de boucle est très élevée, cela peut signifier que le tronçon ABE présente un défaut de continuité. Toutefois, l'emplacement du défaut de continuité n'est pas connu. Le défaut peut par exemple être situé dans l'un des boîtiers de raccordement 10, 11, et doit être localisé pour procéder à la réparation.

Or, à la connaissance de la demanderesse, aucune méthode réellement satisfaisante n'a été proposée à ce jour pour localiser sur le terrain le défaut de continuité d'un écran métallique, les méthodes actuelles reposant essentiellement sur une inspection visuelle.

La présente invention vise à pallier cet inconvénient.

Plus particulièrement, un objectif général de la présente invention est de prévoir un procédé de contrôle d'un élément conducteur applicable à la localisation d'un défaut de continuité électrique, qui soit précis, fiable et simple à mettre en oeuvre.

Un autre objectif de la présente invention est de prévoir un dispositif de contrôle d'un élément conducteur applicable à la localisation d'un défaut de continuité électrique, qui soit d'un encombrement réduit et simple d'emploi.

Pour atteindre cet objectif, la présente invention repose sur la constatation selon laquelle le procédé de localisation complémentaire décrit dans la demande internationale précitée est applicable également à la localisation des défauts de continuité, en calculant la partie imaginaire du courant bifréquence au lieu de calculer la partie réelle. On obtient une valeur de courant purement capacitive qui permet de localiser avec une grande précision un défaut de continuité.

Plus particulièrement, la présente invention prévoit un procédé de contrôle d'un élément conducteur, applicable à la localisation d'un défaut de continuité de l'élément conducteur, l'élément conducteur présentant relativement à un conducteur de référence une résistance d'isolement et une capacité de fuite réparties le long de l'élément conducteur, le procédé comprenant une étape consistant à injecter dans l'élément conducteur au moins deux courants de fréquences distinctes au moyen d'un générateur de courant ou de tension dont une borne est connectée au conducteur de référence, au moins une étape de mesure des amplitudes des courants en un point de mesure choisi le long de l'élément conducteur, et une étape de calcul de la partie imaginaire d'au moins un des courants et/ou de calcul de la capacité de fuite de l'élément conducteur en aval du point de mesure, à partir des amplitudes mesurées des courants.

Selon un mode de réalisation, le procédé comprend une pluralité d'étapes de mesure des amplitudes des courants en divers points de mesure, et une pluralité d'étapes de calcul, après chaque mesure, de la partie imaginaire d'au moins un des courants et/ou de la capacité de fuite aval, un défaut de continuité électrique de l'élément conducteur étant localisé lorsque la partie imaginaire calculée et/ou la capacité de fuite aval s'avère être nulle avant que l'extrémité de l'élément conducteur ne soit atteinte.

La présente invention prévoit également une application du procédé ci-dessus à la localisation d'un défaut d'isolement électrique de l'élément conducteur relativement au conducteur de référence, le procédé comprenant une étape de calcul de la partie réelle d'au moins un des courants et/ou de la résistance d'isolement en aval d'un point de mesure.

Selon un mode de réalisation, le procédé comprend une pluralité d'étapes de mesure des amplitudes des courants en divers points de mesure, et une pluralité d'étapes de calcul, après chaque mesure, de la partie réelle d'au moins un des courants et/ou de la résistance d'isolement aval, un défaut d'isolement électrique étant localisé lorsque la partie réelle calculée présente un net affaiblissement et/ou lorsque la résistance d'isolement aval croît rapidement sans que cela soit justifié par la topographie de l'élément conducteur.

Selon l'invention, le procédé comprend une étape de calcul d'une formule du type :

$$K_x \sqrt{[K_y \ |i_1|^2 \ - \ K_z \ |i_2|^2]},$$

dans laquelle $|i_1|$ et $|i_2|$ sont les amplitudes des courants et $K_x$, $K_y$, $K_z$ sont des constantes.

Selon un mode de réalisation, l'élément conducteur comprend plusieurs écrans de câbles de télécommunication raccordés entre eux, et le conducteur de référence est la terre.

La présente invention concerne également un dispositif de contrôle d'un élément conducteur, comprenant une borne de connexion à un capteur de courant sans contact, un circuit de conversion analogique/numérique du signal délivré par le capteur de courant, et un moyen de calcul, dans lequel le moyen de calcul est agencé pour analyser le signal délivré par le capteur de courant et extraire les amplitudes d'au moins deux courants de fréquences distinctes présents dans le signal délivré, et calculer la partie imaginaire d'au moins un des courants et/ou une capacité électrique, au moyen d'une formule du type : $K_1\sqrt{[K_2 |i_1|^2 - K_3 |i_2|^2]}$, dans laquelle $|i_1|$ et $|i_2|$ sont les amplitudes des courants et $K_1$, $K_2$, $K_3$ sont des constantes.

Selon un mode de réalisation, le moyen de calcul est également agencé pour calculer la partie réelle d'au moins un des courants et/ou une résistance électrique, au moyen d'une formule du type : $K_4\sqrt{[K_5 |i_2|^2 - K_6 |i_1|^2]}$, dans laquelle $K_4$, $K_5$ et $K_6$ sont des constantes.

Selon un mode de réalisation, le dispositif comprend des moyens, de sélection pour choisir entre le calcul de la partie imaginaire d'au moins un des courants et/ou le calcul d'une capacité électrique, d'une part, et le calcul de la partie réelle d'au moins un des courants et/ou d'une résistance électrique, d'autre part.

Selon un mode de réalisation, le dispositif est prévu pour être connecté à une pince ampèremétrique et comprend des bornes d'étalonnage destinées à être interconnectées pendant une phase d'étalonnage, et des moyens pour injecter sur l'une des bornes d'étalonnage au moins deux courants d'étalonnage de fréquences distinctes par l'intermédiaire d'une résistance étalon.

Ces objets caractéristiques et avantages de la présente invention, ainsi que d'autres, seront exposés plus en détail dans la description suivante des fondements théoriques du procédé de l'invention, d'un exemple d'application du procédé de l'invention à la localisation d'un défaut de continuité dans un réseau de câbles de télécommunication, et d'un exemple de réalisation d'un dispositif de mesure selon l'invention, en relation avec les figures jointes parmi lesquelles :

- les figures 1A, 1B précédemment décrites représentent un câble de télécommunication,
- la figure 2 précédemment décrite représente un réseau de câbles de télécommunication,
- la figure 3A représente schématiquement un écran conducteur et illustre le procédé selon l'invention,
- la figure 3B est le schéma électrique équivalent de l'écran de la figure 3A,
- la figure 3C est le schéma équivalent de l'écran de la figure 3A vu depuis un point de mesure,
- les figures 4A, 4B sont des représentations vectorielles de courants intervenant dans le procédé selon l'invention,
- la figure 5 représente de façon simplifiée le réseau de câbles de la figure 2 et illustre une application du procédé selon l'invention,
- les figures 6 à 8 représentent sous forme de courbes les résultats de mesures de courant effectuées sur un tronçon du réseau de la figure 5,
- la figure 9 est une vue externe d'un dispositif de mesure selon l'invention,
- la figure 10 est le schéma électrique sous forme de blocs du dispositif de mesure de la figure 9, et
- la figure 11 illustre une étape d'étalonnage du dispositif de mesure.

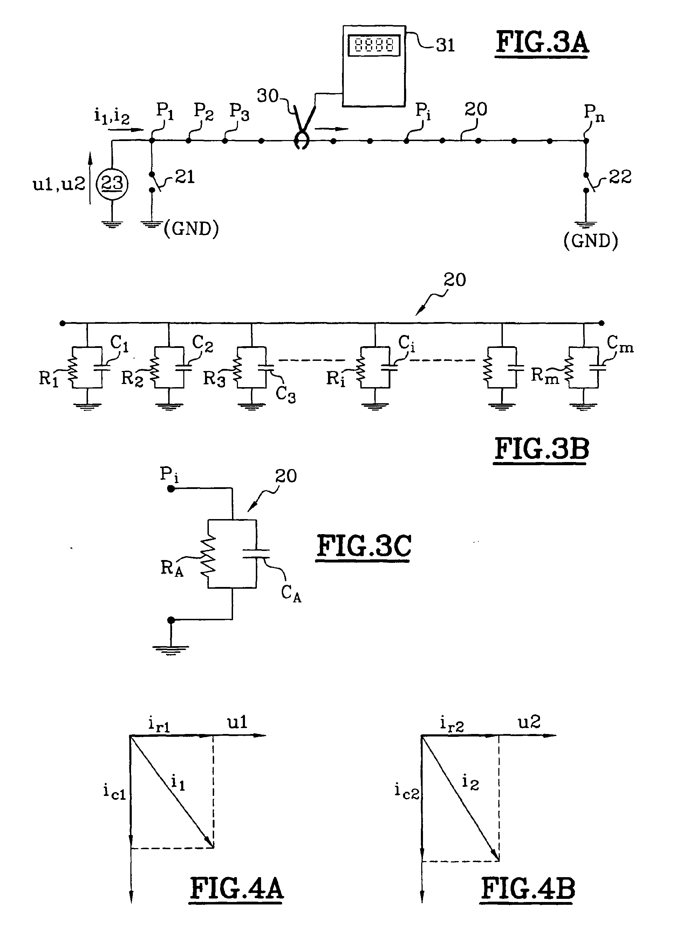

La figure 3A représente schématique l'écran 20 d'un câble de télécommunication dont la continuité électrique doit être contrôlée. Les points d'origine et d'extrémité de l'écran sont préalablement déconnectés de la terre (GND) au moyen de deux interrupteurs 21, 22, par exemple des interrupteurs présents dans des dispositifs IMD. Le schéma équivalent de l'écran 20 est représenté sur la figure 3B. L'écran 20 comprend une pluralité de cellules élémentaires $R_1C_1$, $R_2C_2$, $R_3C_3$ ... $R_iC_i$ ... $R_mC_m$ réparties entre son point d'origine et son point d'extrémité. Les résistances élémentaires $R_i$ forment ensemble la résistance d'isolement de l'écran 20 par rapport à la terre et les capacités élémentaires $C_i$ forment la capacité de fuite de l'écran 20 par rapport à la terre.

Selon l'invention, on injecte au point d'origine de l'écran 20 au moins deux courants $i_1$, $i_2$ basse fréquence de fréquences respectives $f_1$, $f_2$ et de pulsations $\omega_1$, $\omega_2$, par exemple des courants de l'ordre de quelques milliampères oscillant respectivement à 1 Hz et 2 Hz. Les courants $i_1$, $i_2$ sont délivrés par un générateur de tension ou de courant, de préférence un générateur de tension 23 délivrant des tensions alternatives u1, u2 du type

$$\mathtt{u1\ =\ U1\ Cos(2\Pi f_1 t)}$$

$$\mathtt{u2\ =\ U2\ Cos(2\Pi f_2 t)}$$

ayant des amplitudes U1, U2 connues de l'ordre de quelques volts. La borne de masse du générateur 23 est connectée à la terre de manière à former une boucle de conduction passant par l'écran 20 et la terre. Les amplitudes des courants il, $i_2$ sont mesurées en divers points $P_1$, $P_2$, $P_3$... $P_i$...$P_n$ le long de l'écran 20, au moyen d'une pince ampèremétrique 30 connectée à un dispositif de mesure 31.

Ces premières étapes du procédé selon l'invention sont similaires à celles du procédé décrit dans la demande internationale PCT/FR99/02288, qui vise la localisation d'un défaut d'isolement. On va montrer dans ce qui suit que la détection des amplitudes des courants $i_1$ et $i_2$ permet de calculer la partie imaginaire de chaque courant, et que le calcul de la partie imaginaire des courants $i_1$, $i_2$ en plusieurs points de mesure $P_1$, $P_2$,... $P_i$, ... $P_n$ permet de localiser un défaut de continuité.

Vu d'un point de mesure quelconque $P_i$, l'écran 20 peut être représenté comme illustré en figure 3C, sous la forme d'une résistance $R_A$ et d'une capacité $C_A$ en parallèle. La résistance $R_A$ est la résistance d'isolement de la partie de l'écran 20 se trouvant en aval du point de mesure $P_i$, selon le sens d'écoulement des courants il, $i_2$, et est constituée par l'ensemble des résistances d'isolement élémentaires $R_i$ en aval de ce point. La capacité $C_A$ est la capacité de fuite de la partie de l'écran 20 se trouvant en aval du point de mesure $P_i$, et est constituée par l'ensemble des capacités de fuite élémentaires Ci en aval de ce point. La résistance linéique de l'écran 20 étant négligeable, les tensions présentes aux bornes du circuit équivalent $R_A C_A$ sont les tensions u1, u2 d'amplitudes $U_1$, $U_2$ appliquées au point d'origine de l'écran.

La représentation vectorielle des courants il, $i_2$ en figures 4A, 4B montre que chaque courant comprend une partie réelle $i_{r1}$, $i_{r2}$ en phase avec la tension $u_1$, respectivement $u_2$, et une partie imaginaire $i_{c1}$, $i_{c2}$ déphasée de 90° relativement à la partie réelle, qui obéissent aux relations suivantes :

$$(1) \quad |i_1|^2 \ = \ i_{r1}{}^2 \ + \ i_{c1}{}^2$$

$$(2) \quad |i_2|^2 \ = \ i_{r2}{}^2 \ + \ i_{c2}{}^2$$

$|i_1|$ et $|i_2|$ étant les modules, ou amplitudes mesurables, des courants il, $i_2$.

Les parties réelles $i_{r1}$, $i_{r2}$ des courants il, $i_2$ sont liées par les relations suivantes :

$$(3) \quad i_{r1} \ = \ U_1/R_A$$

$$(4) \quad i_{r2} \ = \ U_2/R_A$$

$$(5) \quad R_A \ = \ U_1/i_{r1} \ = \ U_2/ir_2$$

$$(6) \quad i_{r1} \ = \ i_{r2}(U_1/U_2)$$

Les parties imaginaires $i_{c1}$, $i_{c2}$ des courants $i_1$, $i_2$ sont liées par les relations suivantes :

$$(7) \quad i_{c1} \ = \ C_A\omega_1 U_1$$

$$(8) \quad i_{c2} \ = \ C_A\omega_2 U_2$$

$$(9) \quad C_A = i_{c1}/\omega_1 U_1 = i_{c2}/\omega_2 U_2$$

$$(10) \quad i_{c1} = i_{c2} (U_1\omega_1/U_2\omega_2)$$

En injectant dans la relation (1) les expressions des courants $i_{r1}$ et $i_{c1}$ données par les relations (6) et (10), il vient :

$$(11) \quad |i_1|^2 = i_{r2}^2 (U_1/U_2)^2 + i_{c2}^2 (U_1/U_2)^2 (\omega_1/\omega_2)^2$$

En multipliant la relation (2) par le terme $(U_1/U_2)^2$ :

$$(12) \quad |i_2|^2 (U_1/U_2)^2 = i_{r2}^2 (U_1/U_2)^2 + i_{c2}^2 (U_1/U_2)^2$$

En soustrayant la relation (12) à la relation (11), on trouve, après simplification, l'expression du courant $i_{c2}$ :

$$(13) \quad i_{c2} = (\omega_2/U_1) \sqrt{[[(U_2|i_1|)^2 - (U_1|i_2|)^2]/(\omega_1^2 - \omega_2^2)]}$$

En combinant la relation (10) et la relation (13), on trouve l'expression du courant $i_{c1}$ :

$$(14) \quad i_{c1} = (\omega_1/U_2) \sqrt{[[(U_2|i_1|)^2 - (U_1|i_2|)^2]/(\omega_1^2 - \omega_2^2)]}$$

En combinant les relations (7) et (14) comme suit :

$$(15) \quad i_{c1} = C_A\omega_1 U_1 = (\omega_1/U_2)\sqrt{[[(U_2|i_1|)^2 - (U_1|i_2|)^2]/(\omega_1^2 - \omega_2^2)]}$$

on trouve l'expression de la capacité de fuite aval $C_A$ :

$$(16) \quad C_A = (1/U_1 U_2) \sqrt{[[(U_2|i_1|)^2 - (U_1|i_2|)^2]/(\omega_1^2 - \omega_2^2)]}$$

En définitive, les paramètres $U_1$, $U_2$, $\omega_1$ et $\omega_2$ étant des constantes, une formule générale du type :

$$(17) \quad K_1 \sqrt{[K_2 |i_1|^2 - K_3 |i_2|^2]}$$

dans laquelle $|i_1|$ et $|i_2|$ sont les courants mesurés au moyen de la pince ampèremétrique et $K_1$, $K_2$, $K_3$ des constantes, couvre les relations (13) (14) (16) et permet de calculer le courant $i_{c1}$ ou le courant $i_{c2}$, ou encore la capacité de fuite aval $C_A$, selon la valeur donnée aux constantes $K_1$, $K_2$, $K_3$.

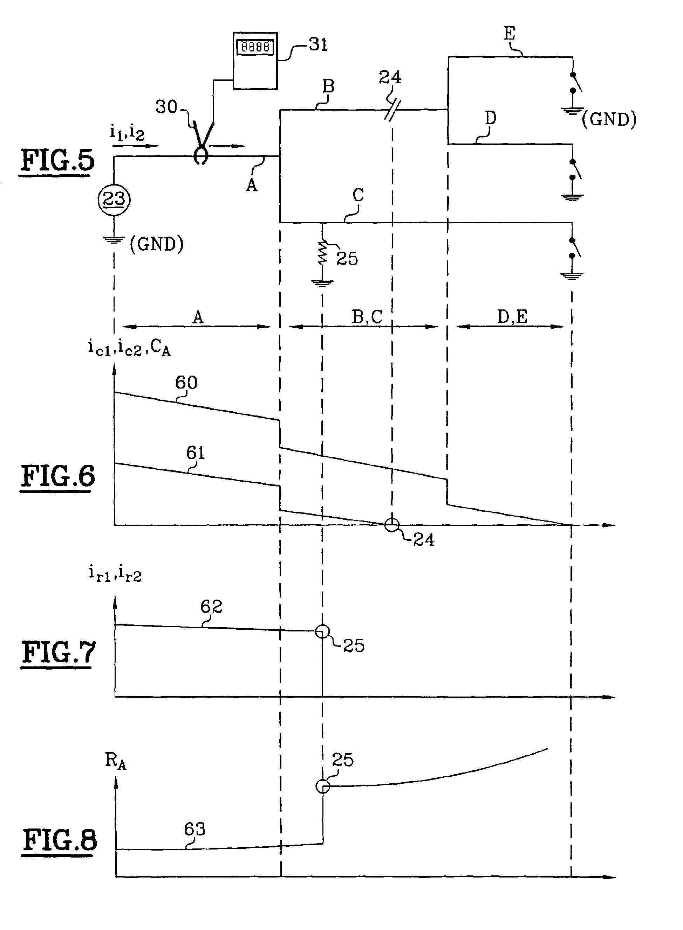

On va maintenant montrer à partir d'un exemple pratique illustré en figure 5 que les relations qui viennent d'être décrites sont directement applicables à la localisation d'un défaut de continuité. La figure 5 représente schématiquement les écrans A, B, C, D, E d'un réseau de câbles de télécommunication semblable à celui de la figure 2. Les écrans sont connectés et forment des tronçons conducteurs AC, ABD et ABE. Le point d'origine de l'écran A et les points d'extrémité des écrans C, D, E sont déconnectés de la terre pour la mise en oeuvre du procédé de l'invention. Le générateur 23 est connecté au point d'origine de l'écran A. Les courants il, $i_2$ circulent dans l'écran A et se divisent dans les écrans B et C, puis dans les écrans D et E.

Sur la figure 6, la courbe 60 représente le profil des courants imaginaires $i_{c1}$, $i_{c2}$ le long du tronçon ABD lorsque celui-ci ne présente pas de défaut de continuité, et la courbe 61 représente le profil des courants $i_{c1}$, $i_{c2}$ en présence d'un défaut de continuité 24 situé ici sur l'écran B. Les courbes 60, 61 représentent également le profil de la capacité aval $C_A$ le long du tronçon ABD, les relations (13) (14) et (16) étant proportionnelles. Ces courbes sont tracées au moyen de la pince ampèremétrique 30 et du dispositif de mesure 31, dont un exemple de réalisation sera décrit plus loin.

Les courbes 60, 61 sont parallèles et présentent une décroissance régulière avec une nette diminution des courants $i_{c1}$, $i_{c2}$ et de la capacité $C_A$ à chaque division du réseau en deux branches distinctes BC et DE. La différence significative entre les deux courbes est que la courbe 60 atteint la valeur zéro à l'extrémité de l'écran D, tandis que la courbe 61, de niveau plus faible, atteint le zéro au point de discontinuité 24. Ainsi, en pratique, il est aisé de localiser le défaut de continuité 24 en observant l'évolution des courants $i_{c1}$, $i_{c2}$ et/ou de la capacité de fuite $C_A$. Lorsque les courants $i_{c1}$, $i_{c2}$ ou la capacité $C_A$ deviennent nuls avant que l'extrémité du tronçon conducteur testé ne soit atteinte, cela signale la présence d'un défaut de continuité.

Par rapport à une simple détection de courant, le procédé de l'invention offre l'avantage d'une grande sensibilité de mesure et d'une excellente précision, et ne nécessite que des courants il, $i_2$ et des tensions u1, u2 de faible valeur, oscillant à basse fréquence et non perturbés par les parasites électromagnétiques présents au voisinage des 50 Hz. Le calcul de la partie imaginaire des courants $i_1$, $i_2$ permet en outre de s'affranchir des pertes de sensibilité dues à un défaut d'isolement, quand le défaut d'isolement n'est pas très important et est par exemple de l'ordre de quelques kilo ohms. En outre, le procédé de l'invention permet de calculer la capacité de fuite $C_A$ et répond à un besoin longtemps ressenti d'analyse des caractéristiques électriques des câbles de télécommunication. Il est toutefois clair que le calcul de la capacité $C_A$ n'est pas indispensable à la localisation d'un défaut de continuité, le procédé pouvant être mis en oeuvre en calculant uniquement la partie imaginaire de l'un des courants il, $i_2$.

Par ailleurs, dans une variante de réalisation du procédé, les tensions U1, U2 sont égales et les relations (13) et (14) se simplifient :

$$(13) \Rightarrow (18) \quad i_{c2} = \omega_2 \sqrt{[(|i_1|^2 - |i_2|^2)/(\omega_1^2 - \omega_2^2)]}$$

$$(14) \Rightarrow (19) \quad i_{c1} = \omega_1 \sqrt{[(|i_1|)^2 - |i_2|^2)/(\omega_1^2 - \omega_2^2)]}$$

Dans ce cas, il n'est pas nécessaire de connaître la tension appliquée U pour calculer les parties imaginaires des courants il, $i_2$ et localiser un défaut de continuité.

On va maintenant compléter l'enseignement de la demande internationale PCT/FR99/02288 et montrer que le procédé qui y est décrit permet de déterminer la partie réelle de chaque courant et la résistance d'isolement $R_A$, dans le cas général ou les tensions U1 et U2 présentent des valeurs quelconques qui ne sont pas forcément identiques. En multipliant la relation (2) donnée plus haut par le terme $(\omega_1 U_1/\omega_2 U_2)^2$, on obtient la relation suivante :

$$(20) \quad (\omega_1 U_1/\omega_2 U_2)^2 |i_2|^2 = (\omega_1 U_1/\omega_2 U_2)^2 i_{r2}^2 + (\omega_1 U_1/\omega_2 U_2)^2 i_{c2}^2$$

En soustrayant la relation (21) à la relation (11), il vient :

$$(21) \quad i_{r2} = (1/U_1) \sqrt{[[(\omega_1 U_1 |i_2|)^2 - (\omega_2 U_2 |i_1|)^2]/(\omega_1^2 - \omega_2^2)]}$$

En combinant les relations (6) et (21) :

$$(22) \quad i_{r1} = (1/U_2) \sqrt{[[(\omega_1 U_1 |i_2|)^2 - (\omega_2 U_2 |i_1|)^2]/(\omega_1^2 - \omega_2^2)]}$$

En combinant la relation (5) avec l'une des relations (21) ou (22) :

$$(23) \quad R_A = U_1 U_2 / \sqrt{[[(\omega_1 U_1 |i_2|)^2 - (\omega_2 U_2 |i_1|)^2]/(\omega_1^2 - \omega_2^2)]}$$

Les paramètres $U_1$, $U_2$, $\omega_1$ et $\omega_2$ étant des constantes, une formule générale du type :

$$(24) \quad K_4 \sqrt{[K_5 |i_2|^2 - K_6 |i_1|^2]}$$

dans laquelle $K_4$, $K_5$, $K_6$ sont des constantes et $|i_1|$, $|i_2|$ les courants mesurés, couvre les relations (21) (22) (23). Selon la valeur donnée aux constantes $K_4$ à $K_6$, cette formule permet de calculer le courant $i_{r1}$, le courant $i_{r2}$ ou encore la résistance $R_A$ (en inversant le résultat).

Comme précédemment, les amplitudes U1, U2 des tensions u1, u2 appliquées au point d'origine peuvent être choisies identiques. Dans ce cas, les courants $i_{r1}$, $i_{r2}$ sont identiques, les relations (21) et (22) se simplifient et deviennent indépendantes de la valeur de la tension U appliquée au point d'origine, ce qui peut permettre de calculer les courants $i_{r1}$, $i_{r2}$ sans connaître la tension U.

Un exemple de localisation d'un défaut d'isolement, ici un défaut 25 présent sur l'écran C en figure 5, est illustré par les courbes 62, 63 des figures 7 et 8. La courbe 62 représente le profil des courants $i_{r1}$, $i_{r2}$ et la courbe 63 représente le profil de la résistance d'isolement aval $R_A$ le long du tronçon AC. En partant du point d'origine de l'écran A, la courbe 62 présente un profil sensiblement plat jusqu'au point de défaut 25, sans diminution sensible des courants $i_{r1}$, $i_{r2}$ au point de division du réseau en deux branches distinctes BC. La majorité du courant passe en effet dans l'écran C en raison du défaut d'isolement 25, qui est très inférieur à la résistance d'isolement des écrans. On observe par contre une chute brutale des courants $i_{r1}$, $i_{r2}$ quand le défaut 25 est atteint. Cette diminution n'est pas liée à la topographie du réseau et est significative de la présence du défaut 25, par l'intermédiaire duquel les courants $i_1$, $i_2$ fuient dans la terre. La courbe 63 de la figure 8 conduit à la même conclusion, la résistance d'isolement aval $R_A$ augmentant brutalement lorsque le défaut d'isolement 25 est atteint.

On décrira maintenant un exemple de réalisation d'un dispositif de mesure 31 selon l'invention, prévu ici pour calculer la capacité de fuite $C_A$ et la résistance d'isolement $R_A$ d'un écran conducteur.

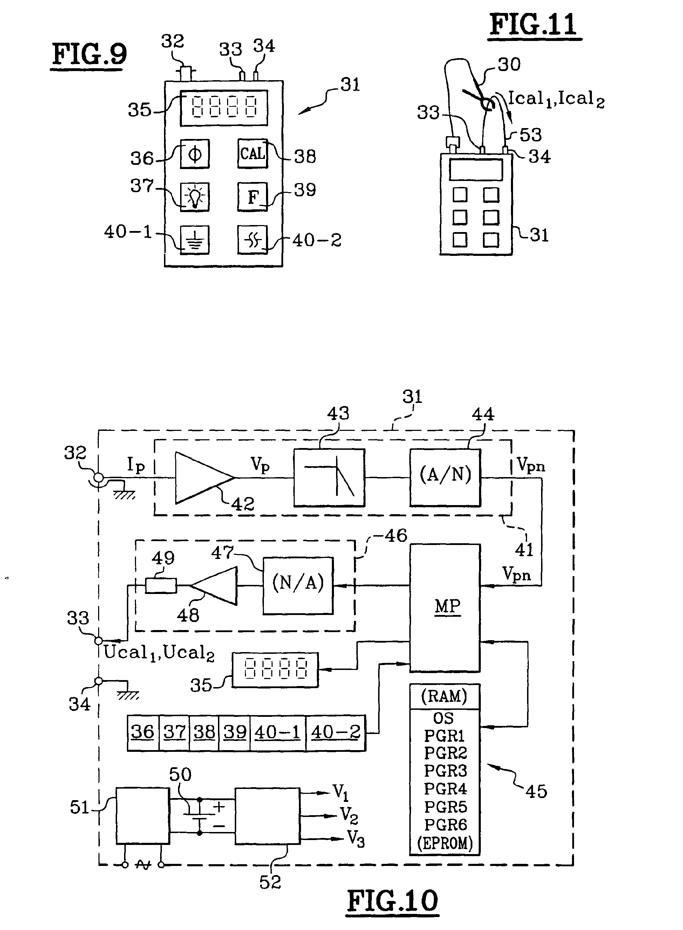

La figure 9 est une vue externe du dispositif 31. Le dispositif 31 comprend une prise 32 de branchement de la pince ampèremétrique, deux bornes d'étalonnage 33, 34, un afficheur 35, une touche marche/arrêt 36, une touche 37 d'éclairage de l'afficheur 35, une touche étalonnage 38, une touche filtrage 39, une touche 40-1 pour déclencher un calcul de résistance d'isolement $R_A$ et une touche 40-2 pour déclencher un calcul de capacité de fuite $C_A$.

La figure 10 représente sous forme de blocs l'architecture électrique du dispositif 31. Celui-ci comprend une chaîne d'échantillonnage 41, un microprocesseur MP pourvu d'une mémoire 45, un circuit d'étalonnage 46, une batterie d'accumulateurs 50, un circuit 51 de charge de la batterie 50 et un circuit de contrôle d'alimentation 52 délivrant diverses tensions V1, V2, V3 nécessaires au fonctionnement des divers éléments. L'afficheur 35 et les touches 36 à 40 sont également représentés et sont connectés au microprocesseur.

La chaîne d'échantillonnage 41 comprend un amplificateur courant/tension 42 dont l'entrée est connectée à la prise 32 et reçoit le courant Ip délivré par la pince ampèremétrique (non représentée). L'amplificateur 42 présente un gain important pour la détection de courants faibles de l'ordre du dixième de microampère en présence de défauts d'isolement de plusieurs centaines de KΩ. La sortie de l'amplificateur 42 délivre une tension Vp et est connectée à l'entrée d'un convertisseur analogiquenumérique 44 par l'intermédiaire d'un filtre passe-bas 43, par exemple un filtre de Butterworth ayant une fréquence de coupure 15 Hz et une forte pente de coupure (-55 dB à 50 Hz) pour éliminer les perturbations à 50 Hz. Le convertisseur 44 est de type sigma-delta à sortie série et comprend un filtre numérique interne

du 6ème ordre. La fréquence d'échantillonnage est choisie à 512 Hz avec une résolution de 16 bits. La sortie du convertisseur 44 délivre un signal échantillonné Vpn envoyé sur une entrée du microprocesseur.

Le circuit d'étalonnage 46 comprend un convertisseur numérique/analogique 47 dont l'entrée numérique est connectée au microprocesseur et dont la sortie est connectée à la borne d'étalonnage 33 par l'intermédiaire d'un amplificateur de tension 48 et d'une résistance étalon 49 de valeur $R_{cal}$.

La mémoire 45 comprend une mémoire volatile de type RAM, pour stocker des données temporaires, et une mémoire rémanente de type EPROM. Essentiellement, la mémoire EPROM comprend le système d'exploitation OS du microprocesseur, un programme PGR1 de Transformée de Fourrier Rapide (FFT), un programme PGR2 de calcul d'amplitude, un programme PGR3 de conversion tension/courant, un programme PGR4 de calcul de capacité de fuite $C_A$ ou de résistance d'isolement $R_A$, un programme d'étalonnage PGR5, et un programme principal PGR6 assurant la coordination de l'ensemble des programmes ainsi que l'exécution des instructions reçues par les touches 36 à 40 et le contrôle des divers éléments du dispositif 31.

Au moyen de ces divers programmes, le microprocesseur extrait du signal échantillonné Vpn deux signaux Vpn1, Vpn2 dont les fréquences respectives correspondent aux fréquences de mesure $f_1$, $f_2$, égales ici à 1Hz et 2Hz, et calcule les amplitudes Vpnmax1, Vpnmax2 de ces signaux Vpn1, Vpn2. Le microprocesseur convertit ensuite les amplitudes Vpnmax1, Vpnmax2 en amplitudes de courants $|i_1|$, $|i_2|$ au moyen de coefficients de conversion KVI1 et KVI2 :

$$(25) \quad |i_1| = \text{KVI1 Vpnmax1}$$

$$(26) \quad |i_2| = \text{KVI2 Vpnmax2}$$

Le microprocesseur calcule ensuite la capacité $C_A$ ou la résistance $R_A$ au moyen des relations (16) ou (23).

Selon un aspect de l'invention, les coefficients de conversion KVI1, KVI2 sont déterminés par le programme d'étalonnage PGR5, qui est activé par un appui sur la touche 38 "CAL" (calibrage). Le programme PGR5 contient une table de données comprenant les valeurs échantillonnées d'un signal bifréquence de fréquences $f_1$, $f_2$. Ces données sont envoyées à l'entrée du convertisseur 47, utilisé comme synthétiseur de fréquences, dont la sortie délivre des tensions analogiques correspondantes. A la sortie de l'amplificateur 48, on trouve deux tensions d'étalonnage $U_{cal1}$, $U_{cal2}$ oscillant aux fréquences de mesure $f_1$, $f_2$. Pendant la phase d'étalonnage, les bornes 33 et 34 sont reliées par un fil conducteur 53 comme représenté sur la figure 11, et la pince ampèremétrique 30 est agencée autour du fil 53. Le fil 53 est traversé par deux courants d'étalonnage $I_{cal1}$, $I_{cal2}$ égaux à :

$$(27) \quad I_{cal1} = U_{cal1}/R_{cal}$$

$$(28) \quad I_{cal2} = U_{cal2}/R_{cal}$$

dont les valeurs sont connues par le programme PGR5. Ces courants sont détectés par la pince 30 et le microprocesseur calcule des valeurs correspondantes Vpnmax1, Vpnmax2 à partir des signaux échantillonnés Vpn1, Vpn2. Les valeurs Vpnmax1, Vpnmax2 permettent au microprocesseur d'étalonner les coefficients de conversion au moyen des relations suivantes :

$$(29) \quad \text{KVI1} = (U_{cal1}/R_{cal})/\text{Vpnmax1} = I_{cal1}/\text{Vpnmax1}$$

$$(30) \quad \text{KVI2} = (U_{cal2}/R_{cal})/\text{Vpnmax2} = I_{cal2}/\text{Vpnmax1}$$

Les tableaux 1, 2 et 3 ci-après résument le fonctionnement du dispositif de mesure 31. Ce dispositif est bien entendu susceptible de diverses variantes et mode de réalisation. Par exemple, on peut se limiter à la réalisation d'un dispositif de mesure calculant seulement les parties imaginaire et réelle d'un courant bifréquence sans calculer la capacité $C_A$ et la résistance $R_A$. Ainsi, les touches 40-1 et 40-2 pourraient servir à déclencher le calcul de la partie réelle et le calcul de la partie imaginaire de l'un des courants il, $i_2$, ce qui serait suffisant pour localiser des défauts d'isolement ou de continuité. Le calcul de la capacité $C_A$ et de la résistance $R_A$ est un avantage supplémentaire permettant d'analyser les caractéristiques électriques d'un câble de télécommunication.

De façon générale, le procédé de l'invention est applicable à tout élément conducteur autre qu'un écran métallique de câble de télécommunication, dans la mesure où l'élément conducteur présente par rapport à la terre ou par rapport à tout autre conducteur utilisé comme conducteur de référence, une capacité de fuite et une résistance d'isolement mesurables.

Egalement, bien que l'on ait décrit dans ce qui précède pour des raisons de simplicité un procédé basé sur l'injection de deux courants, il apparaîtra clairement à l'homme de l'art que les principes et méthodes de calcul exposés plus haut sont transposables à une détection faite au moyen de trois, voire quatre courants ou plus ayant des fréquences distinctes.

**Tableau 1 : Mesure de résistance d'isolement $R_A$**

| | |
|---|---|
| | Impulsion sur la touche 40-1 |
| E1 | Échantillonnage du signal Vp pendant 4,25 secondes à 512 Hz (soit 512 échantillons par seconde). |
| E2 | Suppression des échantillons du signal échantillonné Vpn correspondants aux 25 premiers centièmes de seconde (temps de mise en service du filtre passe-bas 43) |
| E3 | Transformée de Fourier du signal des échantillons Vpn restant avec une finesse d'analyse de 0,25 Hz dans une bande de fréquences allant de 0 Hz à 256 Hz et extraction des signaux Vpn1 et Vpn2 à 1 Hz et 2 Hz |
| E4 | Calcul de l'amplitude Vpnmax1 du signal Vpn1 à 1 Hz et de l'amplitude Vpnmax2 du signal Vpn2 à 2 Hz. |
| E5 | Conversion en valeur de courant des valeurs Vpnmax1, Vpnmax2, au moyen des coefficients de conversion KVI1 et KVI2 : $$\lvert i_1 \rvert = KVI1\ Vpnmax1$$ $$\lvert i_2 \rvert = KVI2\ Vpnmax2$$ |
| E6 | Si mode filtrage sélectionné (touche 39) : étapes E1 à E5 répétées 4 fois ; calcul de la moyenne des quatre derniers résultats : $$\lvert i_1 \rvert = \Sigma_{(4)} \lvert i_1 \rvert / 4$$ $$\lvert i_2 \rvert = \Sigma_{(4)} \lvert i_2 \rvert / 4$$ |
| E7 | Calcul de $R_A$ selon la relation (23) |
| E8 | Affichage de $R_A$ |

**Tableau 2 : Mesure de capacité de fuite $C_A$**

| | |
|---|---|
| | Impulsion sur la touche 40-2 |
| E1 | Etape identique à celle du tableau 1 |
| E2 | Etape identique à celle du tableau 1 |
| E3 | Etape identique à celle du tableau 1 |
| E4 | Etape identique à celle du tableau 1 |
| E5 | Etape identique à celle du tableau 1 |
| E6 | Etape identique à celle du tableau 1 |
| E9 | Calcul de $C_A$ selon la relation (16) |
| E10 | Affichage de $C_A$ |

**Tableau 3 : Etalonnage**

| | | Impulsion sur la touche 38 |
|---|---|---|
| | F1 | Envoi de la tension d'étalonnage $U_{cal}$ sur l'une des bornes d'étalonnage du dispositif |
| | E1 | Etape identique à celle du mode mesure |
| | E2 | Etape identique à celle du mode mesure |
| | E3 | Etape identique à celle du mode mesure |
| | E4 | Etape identique à celle du mode mesure |
| | F2 | Détermination des coefficients de conversion KVI1 KVI2 : $$KVI1 = (U_{cal1}/R_{cal})/Vpnmax1 = I_{cal1}/Vpnmax1$$ $$KVI2 = (U_{cal2}/R_{cal})/Vpnmax2 = I_{cal2}/Vpnmax1$$ |
| | F3 | Répéter trois fois les étapes E1 à E4 et F2 |
| | F4 | Calcul de la moyenne des quatre derniers résultats : $$KVI1 = \Sigma_{(4)} KVI1/4$$ $$KVI2 = \Sigma_{(4)} KVI2/4$$ |
| | F5 | Mise en mémoire des coefficients de conversion |

## Revendications

1. Procédé de contrôle d'un élément conducteur (20, A-E), applicable à la localisation d'un défaut de continuité (24) de l'élément conducteur, l'élément conducteur présentant relativement à un conducteur de référence (GND) une résistance d'isolement ($R_i$) et une capacité de fuite ($C_i$) réparties le long de l'élément conducteur, **caractérisé en ce qu'**il comprend :

   - une étape consistant à injecter dans l'élément conducteur au moins deux courants ($i_1$, $i_2$) de fréquences distinctes ($f_1$, $f_2$) au moyen d'un générateur de courant ou de tension (23) dont une borne est connectée au conducteur de référence (GND),
   - au moins une étape de mesure des amplitudes ($|i_1|$, $|i_2|$) des courants ($i_1$, $i_2$) en un point de mesure ($P_i$) choisi le long de l'élément conducteur, et
   - une étape de calcul de la partie imaginaire ($i_{c1}$, $i_{c2}$) d'au moins un des courants et/ou de calcul de la capacité de fuite ($C_A$) de l'élément conducteur en aval du point de mesure ($P_i$), à partir des amplitudes mesurées des courants et au moyen d'une formule du type :

$$K_x\sqrt{[K_y\ |i_1|^2\ -\ K_z\ |i_2|^2]}$$

   dans laquelle $|i_1|$ et $|i_2|$ sont les amplitudes mesurées des courants et $K_x$, $K_y$, $K_z$ des constantes.

2. Procédé selon la revendication 1, **caractérisé en ce qu'**il comprend une pluralité d'étapes de mesure des amplitudes ($|i_1|$, $|i_2|$) des courants en divers points de mesure ($P_i$), et une pluralité d'étapes de calcul, après chaque mesure, de la partie imaginaire ($i_{c1}$, $i_{c2}$) d'au moins un des courants et/ou de la capacité de fuite aval ($C_A$), un défaut de continuité électrique de l'élément conducteur étant localisé lorsque la partie imaginaire calculée ($i_{c1}$, $i_{c2}$) et/ou la capacité de fuite aval ($C_A$) s'avère être nulle avant que l'extrémité de l'élément conducteur ne soit atteinte.

3. Procédé selon l'une des revendications 1 et 2, applicable à la localisation d'un défaut d'isolement électrique de l'élément conducteur relativement au conducteur de référence, **caractérisé en ce qu'**il comprend une étape de calcul de la partie réelle ($i_{r1}$, $i_{r2}$) d'au moins un des courants ($i_1$, $i_2$) et/ou de la résistance d'isolement ($R_A$) en aval d'un point de mesure ($P_i$).

4. Procédé selon la revendication 3, **caractérisé en ce qu'**il comprend une pluralité d'étapes de mesure des amplitudes ($|i_1|$, $|i_2|$) des courants en divers points de mesure ($P_i$), et une pluralité d'étapes de calcul, après chaque mesure, de la partie réelle ($i_{r1}$, $i_{r2}$) d'au moins un des courants et/ou de la résistance d'isolement aval ($R_A$), un défaut d'isolement électrique étant localisé lorsque la partie réelle calculée ($i_{r1}$, $i_{r2}$) présente un net affaiblissement et/ou lorsque la résistance d'isolement aval ($R_A$) croît rapidement sans que cela soit justifié par la topographie de l'élément conducteur.

**5.** Procédé selon l'une des revendications 1 à 4, **caractérisé en ce que** l'élément conducteur comprend plusieurs écrans de câbles de télécommunication (A-E) raccordés entre eux, et **en ce que** le conducteur de référence est la terre.

**6.** Dispositif (31) de contrôle d'un élément conducteur, comprenant une borne (32) de connexion à un capteur de courant sans contact (30), un circuit (41) de conversion analogique/numérique du signal délivré par le capteur de courant, et un moyen de calcul (MP), **caractérisé en ce que** le moyen de calcul (MP) est agencé pour analyser le signal (Ip) délivré par le capteur de courant et extraire les amplitudes ($|i_1|$, $|i_2|$) d'au moins deux courants ($i_1$, $i_2$) de fréquences distinctes ($f_1$, $f_2$) présents dans le signal délivré (Ip), et calculer la partie imaginaire ($i_{c1}$, $i_{c2}$) d'au moins un des courants ($i_1$, $i_2$) et/ou une capacité électrique ($C_A$) au moyen d'une formule du type :

$$K_1 \sqrt{[K_2 \ |i_1|^2 \ - \ K_3 \ |i_2|^2]}$$

dans laquelle $|i_1|$ et $|i_2|$ sont les amplitudes des courants et $K_1$, $K_2$, $K_3$ sont des constantes.

**7.** Dispositif selon la revendication 6, **caractérisé en ce** le moyen de calcul est également agencé pour calculer la partie réelle ($i_{r1}$, $i_{r2}$) d'au moins un des courants et/ou une résistance électrique ($R_A$), au moyen d'une formule du type :

$$K_4 \sqrt{[K_5 \ |i_2|^2 \ - \ K_6 \ |i_1|^2]}$$

dans laquelle $K_4$, $K_5$ et $K_6$ sont des constantes.

**8.** Dispositif selon l'une des revendications 6 et 7, **caractérisé en ce qu'**il comprend des moyens de sélection (40-1, 40-2) pour choisir entre :

- le calcul de la partie imaginaire $|i_{c1}|$, $i_{c2}$) d'au moins un des courants et/ou le calcul d'une capacité électrique ($C_A$), d'une part, et
- le calcul de la partie réelle ($i_{r1}$, $i_{r2}$) d'au moins un des courants et/ou d'une résistance électrique ($R_A$), d'autre part.

**9.** Dispositif selon l'une des revendications 6 à 8, prévu pour être connecté à une pince ampèremétrique (30), **caractérisé en ce qu'**il comprend des bornes d'étalonnage (33, 34) destinées à être interconnectées pendant une phase d'étalonnage, et des moyens (MP, 46) pour injecter sur l'une des bornes d'étalonnage au moins deux courants d'étalonnage ($I_{cal1}$, $I_{cal2}$) de fréquences distinctes par l'intermédiaire d'une résistance étalon (49, $R_{cal}$).

**Claims**

**1.** A method for controlling a conductive element (20, A-E), applicable to the location of a continuity fault (24) of the conductive element, the conductive element having, relative to a reference conductor (GND), an insulation resistance ($R_i$) and a leakage capacitance ($C_i$) spread along the conductive element, **characterized in that** it comprises:

- a step of injecting into the conductive element at least two currents ($i_1$, $i_2$) of distinct frequencies ($f_1$, $f_2$) by means of a current or voltage generator (23) one terminal of which is connected to the reference conductor (GND),
- at least a step of measuring the amplitudes ($|i_1|$, $|i_2|$) of the currents ($i_1$, $i_2$) at a measuring point ($P_i$) chosen along the conductive element, and
- a step of calculating the imaginary part ($i_{c1}$, $i_{c2}$) of at least one of the currents and/or of calculating the leakage capacitance ($C_A$) of the conductive element downstream from the measuring point ($P_i$), using the measured

amplitudes of the currents and by means of a formula of the type:

$$K_X \sqrt{[K_y \ |i_1|^2 - K_z \ |i_2|^2]}$$

wherein $|i_1|$ and $|i_2|$ are the measured amplitudes of the currents and $K_x$, $K_y$, $K_z$ are constants.

2. Method according to claim 1, **characterized in that** it comprises a plurality of steps of measuring the amplitudes ($|i_1|$, $|i_2|$) of the currents at various measuring points ($P_i$), and a plurality of steps of calculating, after each measurement, the imaginary part ($i_{c1}$, $i_{c2}$) of at least one of the currents and/or of the downstream leakage capacitance ($C_A$), an electrical continuity fault of the conductive element being located when the calculated imaginary part ($i_{c1}$, $i_{c2}$) and/or the downstream leakage capacitance ($C_A$) proves to be zero before the end of the conductive element has been reached.

3. Method according to one of claims 1 and 2, applicable to the location of an electrical insulation fault of the conductive element relative to the reference conductor, **characterized in that** it comprises a step of calculating the real part ($i_{r1}$, $i_{r2}$) of at least one of the currents ($i_1$, $i_2$) and/or of the insulation resistance ($R_A$) downstream from a measuring point ($P_i$).

4. Method according to claim 3, **characterized in that** it comprises a plurality of steps of measuring the amplitudes ($|i_1|$, $|i_2|$) of the currents at various measuring points ($P_i$), and a plurality of steps of calculating, after each measurement, the real part ($i_{r1}$, $i_{r2}$) of at least one of the currents and/or of the downstream insulation resistance ($R_A$), an electrical insulation fault being located when the calculated real part ($i_{r1}$, $i_{r2}$) has clearly declined and/or when the downstream insulation resistance ($R_A$) rapidly increases without this being justified by the topography of the conductive element.

5. Method according to one of claims 1 to 4, **characterized in that** the conductive element comprises several shields of telecommunication cables (A-E) connected to each other, and **in that** the reference conductor is the ground.

6. A device (31) for controlling a conductive element, comprising a terminal (32) for connecting to a contactless current sensor (30), an analog-to-digital conversion circuit (41) for converting the signal delivered by the current sensor, and a calculation means (MP), **characterized in that** the calculation means (MP) is arranged for analyzing the signal (Ip) delivered by the current sensor and extracting the amplitudes ($|i_1|$, $|i_2|$) of at least two currents ($i_1$, $i_2$) of distinct frequencies ($f_1$, $f_2$) present in the signal delivered (Ip), and calculating the imaginary part ($i_{c1}$, $i_{c2}$) of at least one of the currents ($i_1$, $i_2$) and/or an electric capacitance ($C_A$) by means of a formula of the type:

$$K_1 \sqrt{[K_2 \ |i_1|^2 - K_3 \ |i_2|^2]}$$

wherein $|i_1|$ and $|i_2|$ are the amplitudes of the currents and $K_1$, $K_2$, $K_3$ are constants.

7. Device according to claim 6, **characterized in that** the calculation means is also arranged for calculating the real part ($i_{r1}$, $i_{r2}$) of at least one of the currents and/or an electrical resistance ($R_A$), by means of a formula of the type

$$K_4 \sqrt{[K_5 \ |i_2|^2 - K_6 \ |i_1|^2]}$$

wherein $K_4$, $K_5$ and $K_6$ are constants.

8. Device according to one of claims 6 and 7, **characterized in that** it comprises selection means (40-1, 40-2) for choosing between:

- the calculation of the imaginary part ($i_{c1}$, $i_{c2}$) of at least one of the currents and/or the calculation of an electric capacitance ($C_A$), on the one hand, and
- the calculation of the real part ($i_{r1}$, $i_{r2}$) of at least one of the currents and/or of an electrical resistance ($R_A$), on the other hand.

**9.** Device according to one of claims 6 to 8, provided for being connected to a clip-on ammeter (30), **characterized in that** it comprises calibration terminals (33, 34) intended to be interconnected during a calibration phase, and means (MP, 46) for injecting onto one of the calibration terminals at least two calibration currents ($I_{cal1}$, $I_{cal2}$) of distinct frequencies through a standard resistor (49, $R_{CAL}$).

**Patentansprüche**

**1.** Verfahren zur Überwachung eines Leiterelementes (20, A-E), anwendbar auf die Lokalisierung eines Kontinuitätsdefektes (24) des Leiterelementes, wobei das Leiterelement relativ zu einem Bezugsleiter (GND) einen Isolations-widerstand ($R_i$) und eine Streukapazität ($C_i$) aufweist, die über die Länge des Leiterelementes verteilt sind, **dadurch gekennzeichnet, dass** es umfasst:

- einen Schritt, darin bestehend, dass mit Hilfe einer Strom- oder Spannungsquelle (23), die durch einen Anschluss mit dem Bezugsleiter (GND) verbunden ist, in das Leiterelement mindestens zwei Ströme ($i_1$, $i_2$) mit verschiedenen Frequenzen (f1, f2) eingespeist werden,
- mindestens einen Schritt der Messung der Amplituden ($|i_1|$, $|i_2|$) der Ströme ($i_1$, $i_2$) in einem Messpunkt ($P_i$), der auf der Länge des Leiterelementes ausgewählt wurde, und
- einen Schritt der Berechnung des Imaginärteils ($i_{c1}$, $i_{c2}$) mindestens eines der Ströme und/oder der Berechnung der Streukapazität ($C_A$) des Leiterelementes nach dem Messpunkt ($P_i$) aus den gemessenen Amplituden der Ströme und mit Hilfe einer Formel des Typs:

$$K_x \sqrt{\left[ K_y \left| i_1 \right|^2 - K_z \left| i_2 \right|^2 \right]}$$

in der $|i_1|$ und $|i_2|$ die gemessenen Amplituden der Ströme sind und $K_x$, $K_y$, $K_z$ Konstanten.

**2.** Verfahren nach Patentanspruch 1, **dadurch gekennzeichnet, dass** es mehrere Schritte der Messung der Ampli-tuden ($|i_1|$, $|i_2|$) der Ströme in verschiedenen Messpunkten ($P_i$) umfasst und nach jeder Messung mehrere Schritte zur Berechnung des Imaginärteils ($i_{c1}$, $I_{c2}$) mindestens eines der Ströme und/oder der Berechnung der Streukapazität ($C_A$) nach dem Punkt, wobei ein Mangel der elektrischen Kontinuität des Leiters lokalisiert ist, wenn der berechnete Imaginärteil ($i_{c1}$, $i_{c2}$) und/oder die Streukapazität ($C_A$) nach dem Punkt sich als Null ergibt, bevor das Ende des Leiterelementes erreicht ist.

**3.** Verfahren nach einem der Patentansprüche 1 und 2, anwendbar auf die Lokalisierung eines Defektes der elektrischen Isolation des Leiterelementes relativ zum Bezugsleiter, **dadurch gekennzeichnet, dass** es einen Schritt der Be-rechnung des Realteils ($i_{r1}$, $i_{r2}$) mindestens eines der Ströme ($i_1$, $i_2$) umfasst und/oder des Isolationswiderstandes ($R_A$) nach einem Messpunkt ($P_i$) .

**4.** Verfahren nach Patentanspruch 3, **dadurch gekennzeichnet, dass** es mehrere Schritte der Messung der Ampli-tuden ($|i_1|$, $|i_2|$) der Ströme in verschiedenen Messpunkten ($P_i$) umfasst und nach jeder Messung mehrere Schritte zur Berechnung des Realteils ($i_{r1}$, $I_{r2}$) mindestens eines der Ströme und/oder des Isolationswiderstandes ($R_A$) nach dem Punkt, wobei ein Mangel der elektrischen Kontinuität des Leiters lokalisiert ist, wenn der berechnete Realteil ($i_{r1}$, $i_{r2}$) einen deutlichen Abfall aufweist und/oder wenn der Isolationswiderstand ($R_A$) nach dem Punkt schnell anwächst, ohne dass dies durch die Topographie des Leiterelementes gerechtfertigt wäre.

**5.** Verfahren nach einem der Patentansprüche 1 bis 4, **dadurch gekennzeichnet, dass** das Leiterelement mehrere zusammen geschaltete Abschirmungen von Telekommunikationskabeln (A-E) umfasst, und **dadurch**, dass der Bezugsleiter die Erde ist.

**6.** Vorrichtung (31) zur Überwachung eines Leiterelementes, einen Anschluss (32) zur Verbindung mit einem kontaktfreien Stromsensor (30) umfassend, eine Schaltung (41) zur A-nalog/Digitalwandlung des vom Stromsensor ausgegebenen Signals, und ein Rechenmittel (MP), **dadurch gekennzeichnet, dass** das Rechenmittel (MP) dafür eingerichtet ist, das Signal (Ip) zu analysieren, das vom Stromsensor abgegeben wird, und die Amplituden ($|i_1|$, $|i_2|$) mindestens zweier Ströme ($i_1$, $i_2$) mit verschiedenen Frequenzen ($f_1$, $f_2$) zu bestimmen, die im abgegebenen Signal (Ip) enthalten sind, und den Imaginärteil ($i_{c1}$, $i_{c2}$) mindestens eines der Ströme ($i_1$, $i_2$) zu berechnen und/oder eine elektrische Kapazität ($C_A$) mit Hilfe einer Formel des Typs:

$$K_1\sqrt{\left[K_2\left|i_1\right|^2 - K_3\left|i_2\right|^2\right]}$$

in der $|i_1|$ und $|i_2|$ die Amplituden der Ströme sind und $K_1$, $K_2$, $K_3$ Konstanten.

7. Vorrichtung nach Patentanspruch 6, **dadurch gekennzeichnet, dass** das Rechenmittel ebenfalls dafür eingerichtet ist, den Realteil ($i_{r1}$, $i_{r2}$) mindestens eines der Ströme ($i_1$, $i_2$) zu berechnen und/oder einen elektrischen Widerstand ($R_A$) mit Hilfe einer Formel des Typs:

$$K_4\sqrt{\left[K_5\left|i_2\right|^2 - K_6\left|i_1\right|^2\right]}$$

in der $K_4$, $K_5$, $K_6$ Konstanten sind.

8. Vorrichtung nach einem der Patentansprüche 6 und 7, **dadurch gekennzeichnet, dass** sie Auswahlmittel (40 - 1, 40 - 2) umfasst, um unter

   - der Berechnung des Imaginärteils ($i_{c1}$, $i_{c2}$) mindestens eines der Ströme und/oder der Berechnung einer elektrischen Kapazität ($C_A$) einerseits und
   - der Berechnung des Realteils ($i_{r1}$, $i_{r2}$) mindestens eines der Ströme und/oder eines elektrischen Widerstandes ($R_A$) andererseits auszuwählen.

9. Vorrichtung nach einem der Patentansprüche 6 bis 8, dafür vorgesehen, mit einer Strommesszange (30) verbunden zu werden, **dadurch gekennzeichnet, dass** sie Eichklemmen (33, 34) umfasst, die dazu bestimmt sind, während einer Eichphase miteinander verbunden zu werden, und Mittel (MP, 46), um über einen Eichwiderstand (49, $R_{cal}$) an eine der Eichklemmen mindestens zwei Eichströme ($I_{cal1}$, $I_{cal2}$) unterschiedlicher Frequenzen anzulegen.

**FIG.1A**

**FIG.1B**

**FIG.2**

**FIG.3A**

**FIG.3B**

**FIG.3C**

**FIG.4A**

**FIG.4B**

**FIG.5**

**FIG.6**

**FIG.7**

**FIG.8**

# FIG.9

# FIG.11

# FIG.10

**RÉFÉRENCES CITÉES DANS LA DESCRIPTION**

*Cette liste de références citées par le demandeur vise uniquement à aider le lecteur et ne fait pas partie du document de brevet européen. Même si le plus grand soin a été accordé à sa conception, des erreurs ou des omissions ne peuvent être exclues et l'OEB décline toute responsabilité à cet égard.*

**Documents brevets cités dans la description**

- EP 408480 A
- FR 9902288 W
- US 4103225 A